# EUROPEAN PATENT APPLICATION

(11) **EP 4 646 039 A1**
(43) Date of publication of application: **05.11.2025**
(21) Application number: 24305670.2
(22) Date of filing: 29.04.2024
(51) Int. Cl.: H05K 1/09, H05K 3/24, H05K 1/03, H05K 3/06, H05K 3/10, H05K 3/28

(54) **MANUFACTURING METHOD FOR PRINTED CIRCUIT BOARDS AND RELATED USES AND PRODUCTS**

(71) Applicant: Linxens Holding, 78200 Mantes-la-Jolie (FR)
(72) Inventor: SANSON, Jerome, 78910 OSMOY (FR)
(74) Representative: Grünecker Patent- und Rechtsanwälte PartG mbB

(57) **Abstract**

Described is a method of manufacturing a printed circuit board (PCB), comprising the following steps in the given order: a) providing a first conductive layer over and in contact with a substrate, b) providing a plating resist film on a part of the surface of the first conductive layer in a prescribed pattern, c) electroplating a second conductive layer over and in contact with the first conductive layer on the part of the surface of the first conductive layer not covered by the plating resist film, d) removing the plating resist film to expose a part of the first conductive layer not covered by the second conductive layer, and e) etching the first conductive layer to remove the same except at the part on which the second conductive layer was formed; wherein the first conductive layer comprises Au and/or Ag, and the second conductive layer comprises Pt, Rh and/or Ir, or wherein the first conductive layer comprises Ag, and the second conductive layer comprises Au, Pt, Rh and/or Ir. In addition, the use of a conductive layer comprising Au, Pt, Rh and/or Ir as a resist for chemical or electrochemical etching in the manufacture of a PCB is described. Furthermore, a PCB manufactured by the aforementioned method and a medical device comprising said PCB are described.

## Description

### FIELD OF INVENTION

This invention relates to a method of manufacturing a printed circuit board (PCB) which does not require copper or nickel layers and simultaneously enables a high biocompatibility, excellent electrical performance, high production volumes and production efficiency.

In certain embodiments, this invention relates to use of a conductive layer comprising gold, iridium, platinum and/or rhodium as a resist for chemical or electrochemical etching in the manufacture of a printed circuit board, to printed circuit boards and to medical devices comprising said printed circuit boards.

### BACKGROUND OF THE INVENTION

Although printed circuit boards (PCBs) have been widely applied in electronics for decades, the development of devices based on PCB substrates has been the subject of increased research over the years, particularly in the field of biomedical applications, due to potentially low cost factors, commercial availability, the possibility of integrating electronic circuits with ease and providing flex, rigid flex or semi-flex constructions that enable three-dimensional configurations.

Conductive traces and pads in PCBs are generally required to exhibit a favourable solderability, electrical conductivity, wire bondability, and a low resistivity.

In view of its abundance and high conductivity, copper is widely applied for electrical and thermal applications and is the standard metal in PCB devices. To avoid oxidation and improve the solderability of copper contacts and plated through-holes, it is common to subject copper traces to electroless nickel immersion gold (ENIG) or electroless Ni/Pd/Au plating (ENEPIG), for example, wherein a nickel layer prevents the migration and diffusion of copper, and a thin layer of gold protects the nickel from oxidation.

However, especially for medial and/or biological applications, the materials used in PCBs must be carefully selected to ensure that they are compatible with the intended use of the device containing the PCB, sterilization method, and regulatory requirements, and should also be free from contaminants and impurities that could impact the safety and performance of the device.

Due to its chemical instability in aqueous environments, alternatives to copper are therefore sought after. In addition, the use of nickel layers raises concerns with respect to their biocompatibility (see, e.g., G. Genchi et al., "Nickel: Human Health and Environmental Toxicology", Int. J. Environ. Res. Public Health 2020, 17, 679). Hence, it would be desirable to provide printed circuit boards which do not require electrical contacts comprising copper or nickel.

Platinum (Pt) is a commonly used material for electrical contacts. Especially for medical applications (e.g. in neural stimulators or biochemical sensors, working or counter electrodes), electrodes comprising Pt have gained increased interest in view of a high biocompatibility and resistance to oxidation (e.g., by blood, sweat or saline solution).

A number of methods have been proposed to provide Pt-based coatings on insulating substrates.

For example, US 2019/0090357 A1 discloses a method, wherein a primer resin layer having a specific glass transition temperature is provided on a substrate, and spherical nanoparticles of metals in Group 1B or Groups VIIIB are let to sink into the primer resin layer to provide a catalyst layer, and a layer of gold (Au) or platinum (Pt) is deposited on the catalyst layer by electroless plating. However, the primer resin layer tends to be relatively fragile. In addition, said method is time- and energy-consuming and requires specialized equipment (e.g., a specific UV light source), which is in turn accompanied by relatively high costs. Furthermore, a sufficient stability of the electroless plating bath has not been demonstrated to be applicable for large-scale industrial applications.

US 2013/0204318 A1 and WO 2013/117588 A2 disclose thin films for a lead for brain applications, wherein a high conductive metal (such as Au, Cu, Al or Ag) is at least partially encapsulated by a low conductive metal (such as Pt or Ti). The method involves sputter depositing of a low conductive metal layer, selective high conductive metal plating of traces on the low conductive metal layer through a resist mask, patterning of low conductive metal; and low conductive metal electroplating of traces. However, the initial sputtering step in this method limits the design quality and fineness of the traces.

P. A. Köllensperger et al., J. Micromech. Microeng. 2012, 22, 067001, disclose a method of patterning of platinum thin films by chemical wet etching, which involves the subsequent steps of depositing Ti as an underlayer to protect the substrate (Si), Pt deposition by CVD, deposition of a Cr hard mask layer, Cr patterning upon application of a photoresist and etching of the Pt layer with hot *aqua regia.* A selective deposition of Pt is not envisaged in the CVD step, so that the method requires aggressive etching chemicals to remove the exposed Pt, which raises concerns on the applicability of the method on an industrial scale.

In general, it is also known to electroplate conductive metal layers to the surface of insulating substrates by applying a dispersion including carbon particles (e.g., carbon black or graphite) to the surface of the insulating substrate, drying the applied dispersion, and electroplating a conductive metal layer onto the deposited particles (see US 4,619,741 A, for example). While this technique is suitable to electroplate copper layers on insulating substrates, the electric conductivity of the carbon deposit tends to be insufficient for electroplating of platinum and/or rhodium.

In view of the above, it remains desirable to provide a printed circuit board (PCB) and a respective manufacturing method, which do not require copper or nickel layers and simultaneously enable a high biocompatibility, excellent electrical performance (e.g. traces with high electrical conductivity, low resistivity and good wire bondability), and which may be produced cost-efficiently with common PCB manufacturing techniques in an industrial scale.

### SUMMARY OF THE INVENTION

The present invention solves this object with the subject matter of the claims as defined herein. The advantages of the present invention will be further explained in detail in the section below and further advantages will become apparent to the skilled artisan upon consideration of the invention disclosure.

Generally speaking, in one aspect the present invention provides a method of manufacturing a printed circuit board, comprising the following steps in the given order: a) providing a first conductive layer over and in contact with a substrate, b) providing a plating resist film on a part of the surface of the first conductive layer in a prescribed pattern, c) electroplating a second conductive layer over and in contact with the first conductive layer on the part of the surface of the first conductive layer not covered by the plating resist film, d) removing the plating resist film to expose a part of the first conductive layer not covered by the second conductive layer, and e) etching the first conductive layer to remove the same except at the part on which the second conductive layer was formed; wherein the first conductive layer comprises gold (Au) and/or silver (Ag) and the second conductive layer comprises platinum (Pt), rhodium (Rh) and/or iridium (Ir), or wherein the first conductive layer comprises silver (Ag) and the second conductive layer comprises gold (Au), platinum (Pt), rhodium (Rh) and/or iridium (Ir).

In another aspect, the present invention relates to use of a conductive layer comprising platinum and/or rhodium as a resist for chemical or electrochemical etching in the manufacture of a printed circuit board, wherein said conductive layer comprising platinum and/or rhodium is electroplated on a conductive layer comprising gold and/or silver.

In yet another aspect, the present invention relates to a printed circuit board comprising: a substrate; a first conductive layer over and in contact with the substrate; a second conductive layer over and in contact with the first conductive layer; wherein the first conductive layer comprises gold (Au) and/or silver (Ag) and the second conductive layer comprises platinum (Pt), rhodium (Rh) and/or iridium (Ir), or wherein the first conductive layer comprises silver (Ag) and the second conductive layer comprises gold (Au), platinum (Pt), rhodium (Rh) and/or iridium (Ir).

In a further aspect, the present invention relates to a medical device comprising the aforementioned printed circuit board.

### BRIEF DESCRIPTION OF THE DRAWINGS

FIG. 1 is a schematic representation of an exemplary PCB manufacturing method according to the present invention.
FIG. 2A illustrates an example of a PCB arrangement with an optional third conductive layer.
FIG. 2B schematically illustrates an example of a PCB arrangement with an optional protective layer.
FIG. 2C shows an example of a PCB configuration comprising a third conductive layer and a protective layer.

### DETAILED DESCRIPTION OF THE INVENTION

For a more complete understanding of the present invention, reference is now made to the following description of the illustrative embodiments thereof:

### Method of Manufacturing a Printed Circuit Board

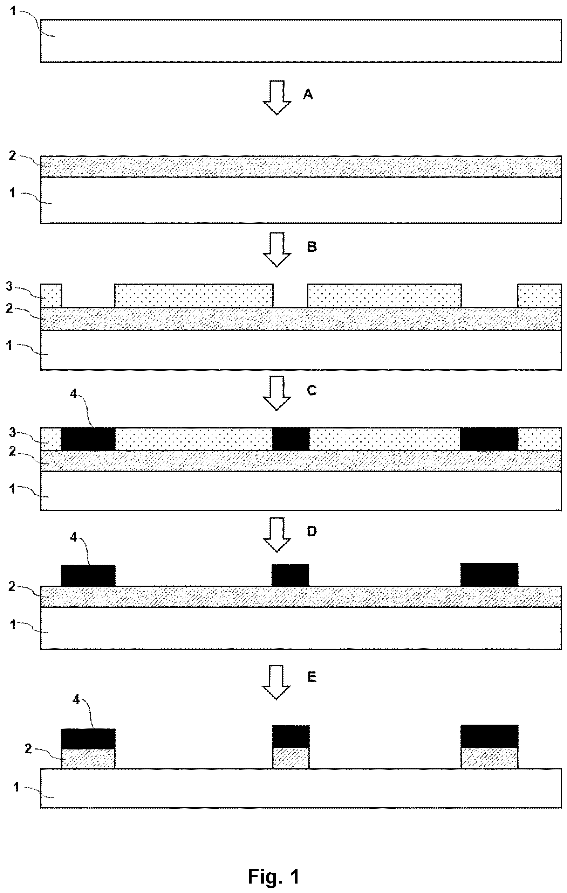

In a first embodiment, the present invention generally relates to a method of manufacturing a printed circuit board, comprising the following steps in the given order: a) providing a first conductive layer over and in contact with a substrate, b) providing a plating resist film on a part of the surface of the first conductive layer in a prescribed pattern, c) electroplating a second conductive layer over and in contact with the first conductive layer on the part of the surface of the first conductive layer not covered by the plating resist film, d) removing the plating resist film to expose a part of the first conductive layer not covered by the second conductive layer, and e) etching the first conductive layer to remove the same except at the part on which the second conductive layer was formed; wherein the first conductive layer comprises Au and/or Ag and the second conductive layer comprises Pt, Rh and/or Ir, or wherein the first conductive layer comprises Ag and the second conductive layer comprises Au, Pt, Rh and/or Ir. An example of the method according to this embodiment of the invention is illustrated in Fig. 1.

In a first step a), a first conductive layer (2) is provided over and in contact with a substrate (1) (see step A in Fig. 1).

The substrate (1) is not particularly limited and may include one or more polymers, silicon, ceramic substrates, glass, fabric, paper and combinations thereof. As examples of polymers, polyetheretherketone (PEEK), polyphenylsulfone (PPSU), polyethylene terephthalate (PET), polyimide (PI), polyetherimide (PEI), liquid crystal polymer (LCP) or epoxy glass may be mentioned, for example), ceramics or paper. Preferred substrate materials from the perspective of biocompatibility include epoxy glass, polyethylene terephthalate (PET), polyetherimide (PEI), among which polyetherimide (PEI) is especially preferred. The substrate thickness is not particularly limited and typically ranges from 10 µm to 5 mm, e.g. from 20 µm to 2 mm, or from 50 µm to 1 mm.

The first conductive layer (2) comprises gold (Au) and/or silver (Ag), in pure form or as alloys comprising gold (Au) and/or silver (Ag) as their principal components. In preferred embodiments, the first conductive layer (2) comprises at least 60 wt.-%, more preferably at least 85 wt.-%, further preferably at least 90 wt.-%, especially preferably at least 95 wt.-% gold (Au) based on the total weight of the first conductive layer (2), such as 97 wt.-% or more or 98 wt.-% or more. Even more preferably, the first conductive layer (2) essentially consists of Au.

In an alternatively preferred embodiment from the perspective of manufacturing costs, the first conductive layer (2) comprises at least 60 wt.-%, more preferably at least 85 wt.-%, further preferably at least 90 wt.-%, especially preferably at least 95 wt.-% silver (Ag) based on the total weight of the first conductive layer (2), such as 97 wt.-% or more or 98 wt.-% or more. It may be especially preferred that the first conductive layer essentially consists of Ag. The described embodiment may be used in combination with a second conductive layer comprising Au.

Notably, the expression "essentially consists of" used herein is generally understood to define that the respective layer consists of the material except from unavoidable impurities, which may be present in an amount of up to 0.5 wt.-% of the respective layer.

Both Au and Ag exhibit a favourably low electric resistivity (i.e. 1.59·10⁻⁸ Ω·m in case of Ag and 2.44·10⁻⁸ Ω·m in case of Au) which is comparable to that of copper (Cu) (1.68·10⁻⁸ Ω·m), thus providing an excellent replacement for Cu traces commonly used in PCB circuits.

In addition, a very thin film of the first conductive layer (2) is sufficient to effectively serve as a base for electroplating of the second conductive layer (4) in step c). In contrast, underlayers based on less conductive metals like Ti (4.21·10⁻⁷ Ω·m), for example, tend to require substantially higher thicknesses for effective Pt/Rh/Ir electroplating. Accordingly, relatively higher costs for the raw materials may be compensated by reduction of the required quantity. In addition, the metals constituting the first conductive layer (2) may be recovered upon etching in step e). The thickness of the first conductive layer (2) is not particularly limited. However, typical thicknesses are 20 nm or higher, such as 25 nm or higher or 50 nm or higher. The upper limit is not particularly limited either, but is typically about 1 µm, 800 nm or 500 nm from the perspective of cost efficiency.

As indicated in Fig. 1, the first conductive layer (2) may be provided on the substrate (1) as a continuous film and no further protection of the substrate (1) is necessary in the further steps. For this purpose, any non-selective method may be employed, such as polymer metallization methods (e.g., physical vapor deposition (PVD), chemical vapor deposition (CVD), electrochemical plating, thermal spray methods (e.g., flame spaying, arc spraying, plasma spraying, and cold spraying)), electroless plating (by immersion with a catalyst or by spray, for example), direct bonding methods (e.g., adhesive bonding, injection overmolding, and fusion joining techniques, including ultrasonic joining, friction spot joining, electromagnetic induction joining, and laser joining), polymer deposition on a film of the first conductive layer and subsequent cross-linking, or combinations thereof.

According to the present invention, the first conductive layer (2) is provided in contact with the substrate (1). The wording "in contact", as used herein, is understood to exclude any metallic interlayers between the first conductive layer (2) and the substrate (1), but may encompass an indirect contact via an adhesive layer (in a laminated configuration, for example).

In step b), a plating resist film (3) is provided on a part of the surface of the first conductive layer (2) in a prescribed pattern (step B in Fig. 1).

For this purpose, a photoresist layer may be laminated over the first conductive layer (e.g. as a dry film), and then selectively exposed and developed to define a desired pattern of traces, for example. Suitable photoresists may be selected by the skilled artisan, and may include any positive or negative photoresists, photopolymeric photoresists, photocrosslinking photoresists, photodecomposing photoresists, or combinations thereof, provided that the resulting patterned resist film is chemically resistant towards the electroplating solution in step c). Examples of photoresists include, but are not limited to polymethylmethacrylate (PMMA), diazoquinone ester, novolac resin, mixtures of diazonaphthaquinone (DNQ) and novolac resin, epoxy-based polymers (e.g. SU-8), acrylate-based polymers off-stoichiometry thiol-enes(OSTE) polymers, hydrogen silsesquioxane (HSQ), etc.. While photoresist films may be provided as liquid films (e.g. by spin coating, spray coating or dip coating), the use of dry film photoresists is generally preferred in view of reduced process times, reduced UV light intensity exposure, and uniform photoresist thickness. To improve the adhesion of the photoresist, the surface of the first conductive layer (2) may be physically pre-treated or adhesion promoters known in the art may be added, for example. The conditions for (photo-)exposure and development as well as suitable reagents may be appropriately selected by the person skilled in the art in dependence of the photoresist used.

The thickness of the plating resist film (3) is not particularly limited, and typically ranges from 50 nm to 500 µm.

In step c), a second conductive layer (4) comprising platinum (Pt), rhodium (Rh) and/or iridium (Ir) (in pure form or as alloys comprising platinum (Pt), rhodium (Rh) and/or iridium (Ir) as their principal components) is electroplated over and in contact with the first conductive layer (2) on the part of the surface of the first conductive layer (2) not covered by the plating resist film (3) (see step C in Fig.1), thus providing a coating with excellent biocompatibility. Moreover, the exposed traces of the first conductive layer (2) are electroplated with metals that not only impart an improved corrosion resistance to the PCB, but are also able to withstand common etching solutions for Ag or Au in the subsequent step d) and hence function as a resist as for chemical or electrochemical etching. Notably, if the first conductive layer (2) comprises Ag, the second conductive layer (4) may comprise Au as an alternative to Pt, Rh, and/or Ir (in pure form or as alloys comprising gold components), taking into account that Au withstands many etching solutions suitable for Ag.

Notably, in comparison to chemical plating methods, electroplating Au, Pt, Rh and/or Ir offers substantial advantages in terms of processing speed. The electrodeposition as such can be performed by galvanostatic, potentiostatic or by potentiocyclic methods, which may be suitably selected by the skilled artisan depending on the desired surface properties and layer stability, for example. Pulsed electrodeposition can be employed to alternate different potentials and thus different processes.

In preferred embodiments, the second conductive layer (4) comprises at least 60 wt.-%, more preferably at least 85 wt.-%, further preferably at least 90 wt.-%, especially preferably at least 95 wt.-% platinum (Pt) based on the total weight of the second conductive layer (4), such as 97 wt.-% or more or 98 wt.-% or more. Even more preferably, the second conductive layer (4) essentially consists of Pt.

A Pt-containing second conductive layer (4) is preferably deposited via electrodeposition from a solution containing a Pt precursor. Generally, such a precursor will be selected from Pt(ll) and Pt(IV) salts. Examples of Pt (II) precursors include, but are not limited to PtCl₄·5 H₂O, H₂PtCl₆·6 H₂O, (NH₄)PtCl₆, Pt(NH₃)₂(NO₂)₂ and dinitrosulphatoplatinites (e.g. based on the complex dihydrogen bis(nitrito-N)[sulphato(2-)-O,O']platinate(2-), H₂Pt(NO₂)₂SO₄), whereas suitable Pt (IV) precursors include, but are not limited to alkali hexahydroxyplatinates (e.g. Na₂Pt(OH)₆ or K₂Pt(OH)₆), phosphate salts (e.g. (NH₄)₂HPO₄, Na₂HPO₄).

In an alternatively preferred embodiment, the second conductive layer (4) comprises at least 60 wt.-%, more preferably at least 85 wt.-%, further preferably at least 90 wt.-%, especially preferably at least 95 wt.-% rhodium (Rh) based on the total weight of the second conductive layer (4), such as 97 wt.-% or more or 98 wt.-% or more. Even more preferably, the second conductive layer (4) essentially consists of Rh.

Rhodium electrodeposition may be brought about by methods known in the art, e.g. by using electroplating baths based on aqueous electrolytes (e.g., sulfate, phosphate, chloride, fluoroborate, sulfamate or ammonium chloride) or ionic liquids (e.g., non-aqueous 1-butyl-3-methylimidazolium chloride ionic liquid medium).

In other preferred embodiments, the second conductive layer (4) comprises at least 60 wt.-%, more preferably at least 85 wt.-%, further preferably at least 90 wt.-%, especially preferably at least 95 wt.-% iridium (Ir) based on the total weight of the second conductive layer (4), such as 97 wt.-% or more or 98 wt.-% or more. Even more preferably, the second conductive layer (4) essentially consists of Ir.

Methods of electrodepositing Ir are not particularly limited and typically employ electroplating baths based on aqueous electrolytes (e.g. containing ammonium chloriridate, iridium bromide, iridium chloride, chloriridic acid and/or iridium chloride-sulfamic acid electrolyte).

The thickness of the second conductive layer (4) is not particularly limited. However, typical thicknesses are 20 nm or higher, such as 25 nm or higher or 50 nm or higher. The upper limit is not particularly limited either, but from the perspective of cost efficiency, it is typically less than 1 µm, such as 900 nm, 800 nm, 700 nm, 600 nm, or 500 nm.

In step d), the plating resist film (3) is then removed to expose a part of the first conductive layer (2) not covered by the second conductive layer (4) (see step D in Fig. 1).

Selective removal of the plating resist film (3) may be brought about by methods known in the art. In preferred embodiments, step d) may be performed by chemical stripping, e.g. by treatment with a suitable stripping solution. The stripping solution is not particularly limited and may be selected from resist removers commonly used in PCB manufacturing provided that the stripping solutions is compatible with the first and the second conductive layers. Exemplary stripping solutions may include alkaline media (e. g., aqueous alkaline solutions of KOH or NaOH) and/or organic solvents (e. g., 1-aminopropan-2-ol, dipropylene glycol methyl ether, tetramethylammonium hydroxide, n-methylpyrrolidone (NMP), dimethyl sulfoxide (DMSO), ethyl lactate ethyl acetate, butyl acetate, methyl ethyl ketone (MEK), propylene glycol methyl ethylene acetate (PGMEA), acetone, cyclopentenone, tetrahydrofuran (THF), dimethyl acetamide, hydrocarbons, cyclic hydrocarbons, or combinations thereof).

In step e), the first conductive layer (2) is then etched to remove the first conductive layer (2) except at the part on which the second conductive layer (4) was formed (see step E in Fig. 1).

In view of low equipment costs, low energy usage and high throughput, wet etching methods are generally preferred and further facilitate the recovery and/or recycling of Au and Ag.

Etching solutions for Au typically require a complexing ligand capable of forming stable Au(I) complexes (which may be selected from cyanide, chloride, iodide, bromide, thiosulfate or thiourea, for example), an oxidant capable of establishing the potential of the surface required for gold dissolution, and optionally one or more further additives selected from stabilizers, inhibitors, wetting agents and pH buffers.

Suitable etchant systems may be selected from aqueous etchants or non-aqueous etchants. Aqueous etchants may include, but are not limited to *aqua regia* (mixture of concentrated hydrochloric and nitric acid, optimally in a molar ratio of 3:1), alkaline cyanide etchants (e.g., formulated from NaCN or KCN salts with O₂, H₂O₂ or Fe(CN)₆³⁻ as the oxidant, iodine-iodide etchants (e.g., formulated from KI or Nal salts and iodine (I₂)), thiosulfate etchants (e.g., formulated from K₂S₂O₃ and KOH using K₃Fe(CN)₆ as an oxidant), and bromine-bromide etchants (e.g., formulated from alkali metal bromide and bromine (Br₂), for example. The etching conditions may be appropriately adjusted to avoid significant dissolution of the second conductive layer. For instance, cold aqua regia (at ≤ 40°C, preferably ≤ 25°C) may be used as Au etchant to avoid or reduce Pt dissolution. As an alternative to aqueous etchants, non-aqueous etchants employing organic solvents may be used. Examples thereof include, but are not limited to bis-diiodine adduct of N,N'-dimethylperhydrodiazepine-2,3-dithione ligand (Me₂dazdt·2I₂) in THF, iodine tetraethylthiuram disulfide (Et₄TDS) mixtures in acetone, and mixtures of thionyl chloride (SOCl₂) and organic solvents such as pyridine and N,N-dimethyl formamide (DMF), or the like. From the viewpoint of simple preparation and application as well as favourably low toxicity, aqueous iodine-iodide etchants (formulated from alkali metal iodide salts and iodine (I₂)) and non-aqueous etchants based on tetraethylthiuram disulfide (Et₄TDS) and I₂ in organic solvents (e.g. acetone) are especially preferred for Au etching.

Ag etching may be performed with a variety of etchants (e.g. Fe³⁺, O₂, and H₂O₂) combined with coordinating ligands (e.g. S₂O₃²⁻, CN⁻, I⁻, Br, Cl⁻, OH⁻, and SCN⁻). Examples include, but are not limited to nitric acid etchants, ammonium persulfate etchants, thiourea etchants, potassium dichromate etchants, ferric nitrate etchants, iodine-iodide etchants (e.g., formulated from alkali metal iodide salts and iodine (I₂)) and etchants based on mixtures of ammonia and hydrogen peroxide diluted with methanol. Among these examples, ferric nitrate etchants, iodine-iodide etchants and etchants based on mixtures of ammonia and hydrogen peroxide diluted with methanol are preferred. When using Au in the second conductive layer, Ag may be selectively etched by methods known in the art. While not being limited thereto, exemplary etching solutions include NH₄OH : H₂O₂: methanol solutions, diluted HNO₃ : HCl mixtures, or piranha (50 H₂SO₄: 1 H₂O₂ at 120°C), for example.

Upon dissolution of Au or Ag in the etching bath, the respective metals may be recovered chemically or electrochemically by methods known to the skilled artisan, in dependence of selected etchant. For instance, Au may be recovered from an aqueous iodide-iodine etching solution by adjusting the etching solution to a strongly basic pH to precipitate metallic gold from the etching solution, and removing the precipitated metallic gold from the resulting alkaline solution. In an alternatively preferred embodiment, metallic Au and/or Ag may be recovered from the etching baths by electrolytic methods.

Advantageously, the methods steps explained above are based on conventional PCB manufacturing technology which is compatible with rapid large scale production and does not require specialized equipment. Potentially higher investments due to increased consumption of precious metals may be counterbalanced by straightforward recovery and/or recycling of excess Au and/or Ag.

In addition, the method of the present invention provides printed circuit boards with excellent biocompatibility, since they do not require copper or nickel, or the use of shadow masks or primer materials. In this respect, it is preferred that the PCB does not comprise a copper layer or a nickel layer. More preferably, the PCB comprises Cu and Ni in a total content of less than 1 wt.-% of the total weight of the PCB, further preferably less than 0.5 wt.-%, and especially preferably less than 0.1 wt.-%, such as 0.05 wt.-% or less.

For selected medical applications, Ag and Au may not deemed sufficiently biocompatible. Accordingly, it may be preferred to cover the exposed side edges of the first conductive layer (2) underneath the second conductive layer (4).

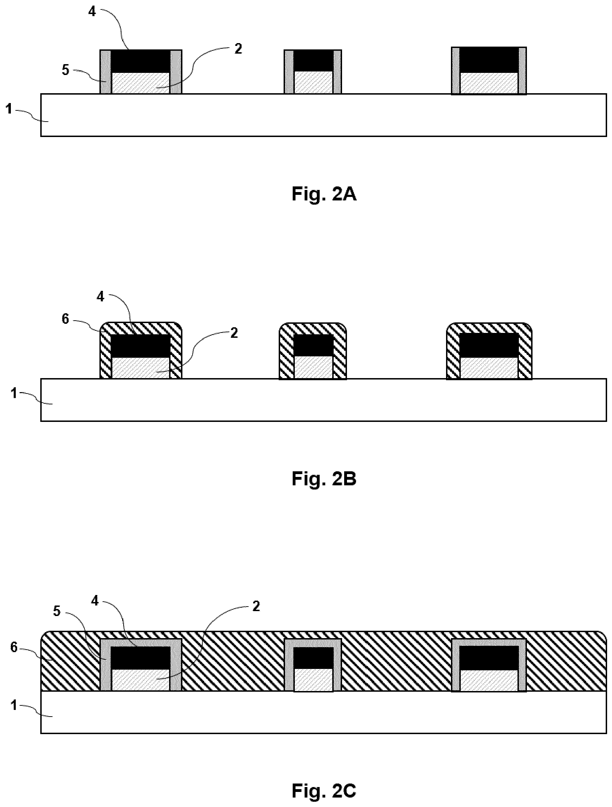

For this purpose, the method of the present invention may further comprise a step of: f1) providing a third conductive layer (5) so as to cover the edge(s) of the first conductive layer (2) exposed upon etching in step e), as is illustrated in Fig. 2A. The third conductive layer (5) may additionally cover the top surface of the second conductive layer (4), as is illustrated in Fig. 2C.

While in principle any biocompatible metal may be used for the third conductive layer (5), such as gold, palladium, palladium and/or rhodium, it is preferred that the third conductive layer (5) comprises Pt, Rh and/or Ir and especially preferably Pt and/or Rh, which significantly enhances the corrosion resistance of the PCB tracks and ensures compatibility with the second conductive layer (4). Moreover, deposition of Pt and/or Rh may be brought about by a further pass of electroplating according to step (c), so than no separate manufacturing step or plating bath is required. In this respect, the compositions and deposition methods as outlined above for the second conductive layer (4) may be employed.

Alternatively or in addition, the method of the present invention may further comprise a step of: f2) providing a protective layer (6) over at least the top and the side edges of the stack formed by the first conductive layer (2) and the second conductive layer (4) (see Fig. 2B) or, if a third conductive layer (5) is present, over at least the top and the side edges of the stack formed by the first conductive layer (2), the second conductive layer (4) and the third conductive layer (5) (see Fig. 2C). The protective layer (6) thus serves as an all-sided encapsulation for the lead tracks and may further function as a solder resist. Notably, the protective layer may be provided locally to encapsulate the individual stack (as illustrated in Fig. 2B) or additionally cover the space between individual stacks (as illustrated in Fig. 2C).

The protective layer (6) is preferably selected from a polymer and/or a ceramic material.

In further preferred embodiments, polymers are selected from biocompatible polymers, more preferably flexible biocompatible polymers, such as poly (p-xylylene) polymers (e.g. parylene), epoxy-based polymers (e.g. SU-8), polyimide, polyurethane or silicone, for example. Polymer-based protective layers may be provided by application in liquid form and subsequent curing, or as a so-called coverlay, i.e. a solid sheet of polymer which is adhered to the trace structure. As examples of ceramic materials, SiN, SiOₓ, SiC, alumina or TiN may be mentioned, which may be applied by deposition processes known in the art, such as CVD, PVD or ALD, for example. The thickness of the protective layer may be appropriately selected according to the required properties, and may be non-uniform.

Notably, the protective layer (6) may be a single layer or exhibit a multilayer structure. For instance, a layer of ceramic material may be provided over at least the top and the side edges of the metallic stack, and a layer of polymer may be applied over the sublayer of ceramic material.

Accordingly, a PCB with excellent biocompatibility, physical properties, chemical resistance and/or flexibility, which may find use in a wide range of medical applications, may be provided rapidly and at a large scale.

### Use of a conductive layer comprising Pt, Rh, Ir and/or Au as an etching resist in PCB manufacturing

In a second embodiment, the present invention relates to use of a conductive layer comprising Pt, Rh and/or Ir as a resist for chemical or electrochemical etching in the manufacture of a PCB, wherein said conductive layer comprising platinum Pt, Rh and/or Ir is electroplated on a conductive layer comprising Au and/or Ag. Alternatively, the second embodiment relates to use of a conductive layer comprising Au, Pt, Rh and/or Ir as a resist for chemical or electrochemical etching in the manufacture of a PCB, wherein said conductive layer comprising Au, Pt, Rh and/or Ir is electroplated on a conductive layer comprising Ag. The use provides the possibility to prepare biocompatible PCBs at a large scale with standard equipment and high productivity.

In preferred embodiments, the manufacture of the PCB is performed in accordance to the first embodiment described above.

### Printed circuit board (PCB)

In a third embodiment, the present invention relates to a printed circuit board comprising: a substrate; a first conductive layer over and in contact with the substrate; a second conductive layer over and in contact with the first conductive layer; wherein the first conductive layer comprises Au and/or Ag and the second conductive layer comprises Pt, Rh and/or Ir, or wherein the first conductive layer comprises Ag and the second conductive layer comprises Au, Pt, Rh and/or Ir .

Details of the constituent members are described in conjunction with the first embodiment above.

The PCB according to the present invention may be flexible or rigid.

Features for through-hole and/or surface-mount technology may be suitably adopted from conventional PCB manufacturing. Notably, the PCB may be single-sided (having one or more stacks of the first conductive layer and the second conductive layer on one side of the substrate), double-sided (one or more stacks on both sides of one substrate layer), or multilayered (outer and inner layers of conductive stacks, alternating with layers of substrate), provided that the above-defined configuration is met.

In a preferred embodiment, the PCB according to the present invention is a double-sided PCB, wherein stacks of the first conductive layer, the second conductive layer, the optional third conductive layer and the optional protective layer as described in conjunction with the first embodiment are patterned as electrically conductive traces on each side of a substrate. Herein, the stacks on each side of the substrate may be selected independently from the above-described materials. In embodiments, the traces on the opposed sides may be electrically connected by conductive vias as desired. The material for the conductive vias may be suitably selected by the skilled artisan from materials known in the art depending on the envisaged application.

### Medical devices

In a fourth embodiment, the present invention relates to a medical device comprising the printed circuit board according to the third embodiment.

Due to the excellent biocompatibility, the printed circuit boards of the present invention may be employed in a vast range of medical devices. Examples thereof include sensor devices (e.g., body temperature monitors, blood glucose monitors or blood pressure monitors), electro-medical implants (e.g. pacemakers, hearing aids, heart pumps, defibrillators, neuromodulation devices), nerve stimulation units, medical imaging devices, monitoring devices (e.g., infusion fluid controls, EMG activity systems) and electrical muscle stimulation equipment.

It will be appreciated that the present invention may employ any of the preferred features specified above with respect to the description of the first to fourth embodiments, and that the preferred features may be combined in any combination, except for combinations, where at least some of the features are mutually exclusive.

Once given the above disclosure, many other features, modifications, and improvements will become apparent to the skilled artisan.

### Reference Numerals

- 1: substrate
- 2: first conductive layer
- 3: plating resist film
- 4: second conductive layer
- 5: optional third conductive layer
- 6: optional protective layer

## Claims

1. Method of manufacturing a printed circuit board, comprising the following steps in the given order:
a) providing a first conductive layer over and in contact with a substrate,
b) providing a plating resist film on a part of the surface of the first conductive layer in a prescribed pattern,
c) electroplating a second conductive layer over and in contact with the first conductive layer on the part of the surface of the first conductive layer not covered by the plating resist film,
d) removing the plating resist film to expose a part of the first conductive layer not covered by the second conductive layer, and
e) etching the first conductive layer to remove the same except at the part on which the second conductive layer was formed;
wherein the first conductive layer comprises gold and/or silver and the second conductive layer comprises platinum, rhodium and/or iridium, or
wherein the first conductive layer comprises silver, and the second conductive layer comprises gold, platinum, rhodium and/or iridium.

2. Method according to claim 1, wherein the printed circuit board does not comprise a copper layer or a nickel layer.

3. Method according to claim 1 or claim 2, wherein the substrate is selected from the group consisting of polymers, silicon, ceramic substrates, glass, fabric, paper and combinations thereof, and wherein the substrate is preferably selected from epoxy glass, polyethylene terephthalate (PET), polyetheretherketone (PEEK), polyphenylsulfone (PPSU), polyimide (PI), polyetherimide (PEI), liquid crystal polymer (LCP) or combinations thereof.

4. Method according to any one of claims 1 to 3, wherein step d) is performed by chemical stripping.

5. Method according to any one of claims 1 to 4, wherein step e) is performed by chemical etching.

6. Method according to any one of claims 1 to 5, further comprising a step of:
f1) providing a third conductive layer to cover an edge of the first conductive layer exposed upon etching in step e).

7. Method according to claim 6, wherein the third conductive layer comprises gold, palladium, platinum, rhodium and/or iridium, and preferably platinum and/or rhodium.

8. Method according to any one of claims 1 to 7, further comprising a step of:
f2) providing a protective layer over at least the top and the side edges of the stack formed by the first conductive layer, the second conductive layer and, if present, the third conductive layer.

9. Method according to claim 8, wherein the protective layer comprises a polymer and/or a ceramic material.

10. Method according to any one of claims 1 to 9;
wherein the first conductive layer gold and/or silver, and the second conductive layer comprises platinum, rhodium and/or iridium, and
the first conductive layer comprises at least 85 wt.-%, preferably at least 90 wt.-% and more preferably at least 95 wt.-% gold and/or silver based on the total weight of the first conductive layer, and/or
the second conductive layer comprises at least 85 wt.-%, preferably at least 90 wt.-% and more preferably at least 95 wt.-% platinum, rhodium and/or iridium based on the total weight of the second conductive layer; or
wherein the first conductive layer comprises silver, and the second conductive layer comprises gold, platinum, rhodium and/or iridium, and
the first conductive layer comprises at least 85 wt.-%, preferably at least 90 wt.-% and more preferably at least 95 wt.-% silver based on the total weight of the first conductive layer, and/or
the second conductive layer comprises at least 85 wt.-%, preferably at least 90 wt.-% and more preferably at least 95 wt.-% gold, platinum, rhodium and/or iridium based on the total weight of the second conductive layer.

11. Use of a conductive layer comprising platinum, rhodium and/or iridium as a resist for chemical or electrochemical etching in the manufacture of a printed circuit board, wherein said conductive layer comprising platinum, rhodium and/or iridium is electroplated on a conductive layer comprising gold and/or silver.

12. Use of a conductive layer comprising gold, platinum, rhodium and/or iridium as a resist for chemical or electrochemical etching in the manufacture of a printed circuit board, wherein said conductive layer comprising gold, platinum, rhodium and/or iridium is electroplated on a conductive layer comprising silver.

13. Use according to claims 11 or 12, wherein the manufacture of the printed circuit board is performed according to the method of any one of claims 1 to 11.

14. Printed circuit board comprising:
a substrate;
a first conductive layer over and in contact with the substrate;
a second conductive layer over and in contact with the first conductive layer;
wherein the first conductive layer comprises gold and/or silver, and the second conductive layer comprises platinum, rhodium and/or iridium, or
wherein the first conductive layer comprises silver, and the second conductive layer comprises gold, platinum, rhodium and/or iridium.

15. Medical device comprising the printed circuit board according to claim 14.
